# FASCICULE DE BREVET EUROPEEN

(11) **EP 3 197 247 B1**
(45) Date de publication et mention de la délivrance du brevet: **03.12.2025**
(21) Numéro de dépôt: 17151501.8
(22) Date de dépôt: 13.01.2017
(51) Int. Cl.: H05K 1/11, H05K 3/34

(54) **CARTE ELECTRONIQUE DESTINEE A RECEVOIR UN COMPOSANT ELECTRONIQUE**
ELEKTRONISCHE KARTE ZUR AUFNAHME EINES ELEKTRONISCHEN BAUTEILS
ELECTRONIC CARD INTENDED FOR RECEIVING AN ELECTRONIC COMPONENT

(30) Priorité: 20.01.2016 FR 1650455
(43) Date de publication de la demande: 26.07.2017
(73) Titulaire: Valeo Electrification, 95800 Cergy (FR)
(72) Inventeur: Martin, Francois, 95800-Cergy Saint Christophe (FR)
(74) Mandataire: Valeo Powertrain Systems

(56) Documents cités:
- US-A- 5 426 266
- US-A1- 2003 064 546
- US-A1- 2003 141 103
- US-A1- 2013 083 489

## Description

La présente invention concerne une carte électronique destinée à recevoir un composant électronique, un ensemble comprenant une telle carte électronique, ainsi qu'un procédé de montage d'un composant électronique sur la carte électronique.

Une carte électronique, notamment une carte de circuit imprimé, comprend un support généralement rigide sur lequel un composant électronique peut être monté. Il est connu de braser le composant électronique sur une zone de réception du composant électronique formée par un plot métallique.

Lors du brasage du composant électronique, du gaz peut être généré par évaporation des solvants de la pâte à braser. Ce gaz peut se retrouver piégé dans la brasure, formant alors des bulles dans celle-ci. Des bulles peuvent même s'agglomérer formant alors des bulles de grande taille qui peuvent s'étendre sur une hauteur non négligeable de la brasure entre le composant et le plot métallique. Le plot métallique sert typiquement de dissipateur thermique pour le composant électronique. Ces bulles de gaz sont préjudiciables au refroidissement du composant car elles introduisent des zones faiblement conductrices thermiquement dans l'épaisseur de la brasure.

Il est connu de former dans la face de montage du plot métallique des canaux pour évacuer les gaz formés lors du brasage du composant électronique. Par exemple, la publication de demande brevet aux Etats-Unis US2003/0141103 décrit un plot métallique ayant des canaux d'évacuation s'étendant radialement depuis une zone centrale du plot vers la périphérie du plot. Lors du brasage, les canaux d'évacuation acheminent donc le gaz formé dans la zone centrale vers l'extrémité distale du canal pour l'évacuer.

Le document US 2013/083489 A1 décrit également des exemples de plots métalliques comportant des canaux d'évacuation des gaz.

Cependant, le composant électronique comprend généralement un boitier qui loge l'élément proprement électronique. Par exemple, le composant peut avoir un boitier de type D2PAK connu en soit. Or, l'élément électronique du composant électronique n'étant pas forcément au centre du boitier, il ne se retrouve pas forcément sur la zone centrale du plot métallique, et se retrouve donc sur une zone ou le drainage des gaz a pu être moins efficace laissant subsister plus de bulles que dans la zone centrale. Le refroidissement de l'élément électronique, qui est la portion du composant qui produit de la chaleur, en est donc pénalisé.

Il est donc recherché une carte électronique comprenant une zone de montage de composants électroniques par brasage, permettant d'obtenir une brasure avec le moins de bulles possible sous la partie du composant électronique qui produit de la chaleur.

A cet effet, il est proposé un ensemble comprenant:
- un composant électronique comprenant un boitier et un élément électronique logé dans ledit boitier, et
- une carte électronique destinée à recevoir ledit composant électronique, ladite carte électronique comprenant un plot métallique formant un pavé ayant une face, dite face de montage, destinée à recevoir le composant électronique par brasage, ladite face de montage comportant au moins un canal qui débouche sur la périphérie de la face de montage et qui est configuré pour évacuer des gaz formés lors du brasage du composant électronique, le canal débute à proximité d'un premier côté périphérique de la face de montage en s'étendant depuis une première moitié de la face de montage jusqu'à une deuxième moitié de la face de montage, le canal débute à une distance du premier côté périphérique, ladite distance étant inférieure à h/2 où h est la distance qui sépare le premier côté périphérique d'un autre côté périphérique de la face, dit deuxième côté périphérique, qui lui est opposé,
dans lequel le canal débute à une première extrémité fermée à la diffusion de gaz et se termine à une deuxième extrémité ouverte à la diffusion de gaz, de sorte que lors du brasage les gaz se propagent dans une direction suivant la première extrémité vers la deuxième extrémité du canal et dans lequel ledit composant électronique est brasé sur la face de montage, son élément électronique étant positionné sur une portion de la face de montage où débute le ou les canaux d'évacuation des gaz.

Généralement, et c'est en particulier le cas pour les composants de boitier de type D2PAK, DPAK, ou TO 220, l'élément électronique du composant électronique est situé dans une zone non centrale du boitier. Grâce aux canaux d'évacuation dans la carte électronique selon l'invention, on s'assure que les gaz sont évacués principalement depuis une zone non centrale du plot métallique lors du brasage du composant électronique. Ainsi, en positionnant le composant électronique de sorte que l'élément électronique du composant électronique soit sur cette zone non centrale du plot métallique, on s'assure que la densité de bulles est minimale dans la brasure située entre le plot métallique et la face de l'élément électronique qui est en vis-à-vis de la face de montage.

Selon un mode de réalisation, le canal débouche au niveau d'un sommet de la face de montage.

Selon un mode de réalisation, le début du canal est en vis-à-vis du milieu du premier côté périphérique.

Le canal débute à une distance du premier côté périphérique, ladite distance étant inférieure à h/2 où h est la distance qui sépare le premier côté périphérique d'un autre côté périphérique de la face, dit deuxième côté périphérique, qui lui est opposé.

Selon un mode de réalisation, la carte électronique comprend une pluralité dudit canal. Autrement dit, ladite face de montage comporte plusieurs canaux qui débouchent sur la périphérie de la face et qui sont configurés pour évacuer des gaz formés lors du brasage du composant électronique. Les canaux débutent à proximité d'un premier côté périphérique de la face et s'étendent jusqu'à un deuxième côté périphérique de ladite face, les canaux s'étendant en outre depuis une première moitié de la face jusqu'à une deuxième moitié de la face.

Selon un mode de réalisation, un premier canal et un deuxième canal débouchent au niveau d'un sommet respectif de la face de montage, les deux canaux étant symétriques par rapport à un axe de symétrie de la face de montage.

Selon un mode de réalisation, un troisième canal débute en vis-à-vis du milieu du premier côté périphérique et s'étend le long de l'axe de symétrie de la face de montage pour déboucher sur un côté périphérique de la face de montage.

Selon un mode de réalisation, un quatrième canal d'évacuation des gaz s'étend depuis un sommet contigu au premier côté périphérique, ledit quatrième canal étant débouchant à son extrémité au niveau dudit sommet et non débouchant à son autre extrémité.

Selon un mode de réalisation, un cinquième canal d'évacuation des gaz s'étend depuis un deuxième côté périphérique opposé au premier côté périphérique ; ledit cinquième canal étant débouchant à son extrémité au niveau dudit deuxième côté périphérique et non débouchant à son autre extrémité.

Selon un mode de réalisation l'élément électronique est en forme de pavé et le composant électronique est monté sur la face de montage de sorte que l'élément électronique soit symétrique par rapport l'axe de symétrie, et a un côté sensiblement parallèle au premier côté périphérique de la face de montage,
ledit côté de l'élément électronique et les premier et deuxième et/ou troisième canaux sont tels que les débuts du premier canal et du deuxième canal et/ou du troisième canal sont en vis-à-vis d'un point dudit côté de l'élément électronique.

Selon un mode de réalisation, ce point est à une distance à partir du milieu dudit côté de l'élément électronique, ladite distance étant égale à L/3 où L est la moitié dudit côté de l'élément électronique.

L'invention concerne aussi un procédé de montage d'un composant électronique sur une carte électronique comprenant :
- la fourniture d'une carte électronique selon l'invention ;
- le dépôt de brasure sur la face de montage du plot métallique ;
- le dépôt du composant électronique sur la couche de brasure et le brasage du composant électronique sur la face de montage,
dans lequel le dépôt de brasure s'effectue à l'aide d'un masque occultant le ou les canaux d'évacuation des gaz de manière à empêcher un dépôt de brasure dans le ou lesdits canaux d'évacuation des gaz.

L'invention va être décrite en détail dans la description qui suit en liaison avec les dessins ci-annexés. Il est à noter que ces dessins n'ont d'autre but que d'illustrer le texte de la description et ne constituent en aucune sorte une limitation de la portée de l'invention.
La figure 1 illustre un premier exemple de carte électronique selon l'invention.
La figure 2 illustre un deuxième exemple de carte électronique selon l'invention.
La figure 3 représente une vue agrandie d'un plot métallique utilisé dans une carte électronique selon l'invention, muni d'un composant électronique.

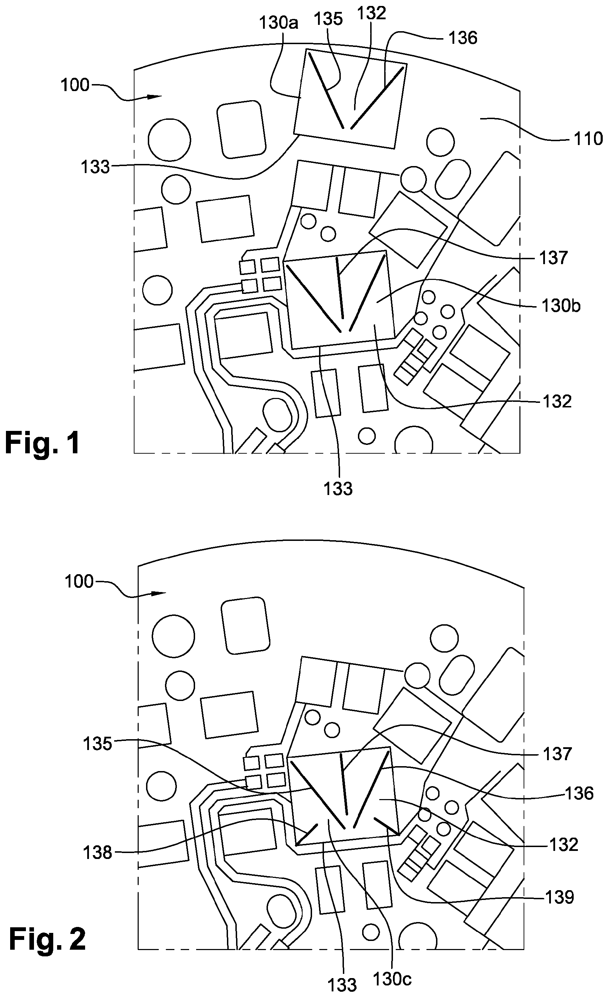

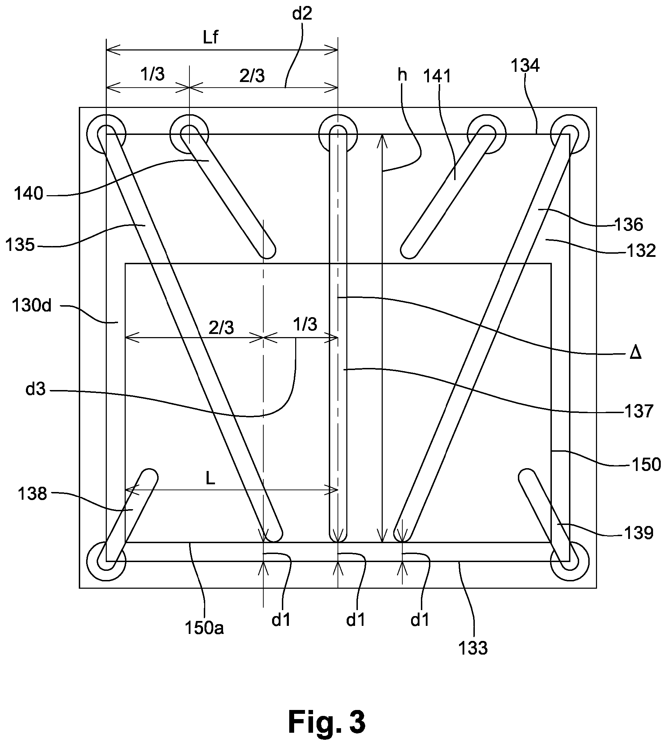

Les figures 1 à 3 illustrent des exemples de carte électronique 100 selon l'invention. La carte électronique 100 peut comprendre les caractéristiques d'une carte électronique connue en soit, telle qu'une carte de circuit imprimé. Notamment, la carte électronique 100 comprend un support 110, par exemple rigide.

La carte électronique 100 comprend des plots métalliques 130a, 130b, 130c, 130d, formés sur le support 110, destinés à recevoir des composants électroniques brasés respectifs. Les plots métalliques 130a, 130b, 130c, 130d sont en forme de pavé. En particulier, les plots métalliques 130a, 130b, 130c, 130d forment des parallélépipèdes, notamment des parallélépipèdes rectangles. Chaque plot métallique 130a, 130b, 130c, 130d a une face, dite face de montage 132, sur laquelle le composant électronique va être brasé. La face de montage 132 est notamment une face opposée à la face du plot métallique 130a, 130b, 130c, 130d qui est en contact avec le support 110.

Dans les plots métalliques 130a, 130b, 130c, 130d, les faces de montage 132 respectives comportent au moins un canal 135, 136, 137, 138, 139, 140, 141 qui est destiné à évacuer des gaz formés lors du brasage du composant électronique sur la face de montage 132. Chaque canal est notamment une gorge dont la profondeur s'étend sur toute l'épaisseur du plot métallique. La profondeur de la gorge pourrait être inférieure à l'épaisseur du plot métallique, cependant le taux d'évacuation des gaz pourrait en être diminué. Le canal d'évacuation des gaz prend naissance dans la face de montage 132 et débouche sur la périphérie de la face de montage 132. Autrement dit, le canal débute à une première extrémité fermée à la diffusion de gaz et se termine à une deuxième extrémité ouverte à la diffusion de gaz, de sorte que lors du brasage les gaz se propagent dans une direction suivant la première extrémité vers la deuxième extrémité du canal.

Un premier canal 135 et un deuxième canal 136 débutent chacun à proximité d'un premier côté périphérique 133 de la face montage 132 et s'étendent depuis une première moitié de la face de montage 132 vers une deuxième moitié de la face de montage 132 où ils vont déboucher en périphérie de la face de montage 132. Ainsi, le plot métallique 130a, 130b, 130c, 130d est particulièrement adapté au montage d'un composant électronique dans lequel l'élément électronique n'est pas situé dans une zone centrale du boitier du composant, notamment dans une zone centrale d'une portion du boitier qui est destinée à être brasée sur la face de montage. Un tel composant sera désigné dans ce qui suit par l'expression « composant dissymétrique ». Le composant électronique est positionné de façon que son élément électronique soit positionné sur une portion de la face de montage 132 où débute le canal d'évacuation des gaz 135, 136. Ainsi, on évite la formation de bulles directement sous l'élément électronique du composant électronique, ce qui améliore la dissipation thermique du composant électronique.

Comme illustrés sur les plots métalliques 130a, 130b, 130c, 130d, le premier canal 135 et le deuxième canal 136 d'évacuation des gaz débutent notamment à une distance d1 du premier côté périphérique 133 du plot métallique 130a, 130b, 130c, 130d. Cette distance d1 est inférieure à la moitié de la distance h entre le premier côté périphérique 133 et un deuxième côté périphérique 134 qui est opposé au premier côté périphérique 133.

En particulier, la face de montage 132 forme un rectangle. Des moitiés de la face de montage 132 peuvent être définies par une droite parallèle au premier 133 et au deuxième 134 côté périphérique et passant au milieu de la distance h qui sépare les deux côtés périphériques 133, 134. En s'assurant que le début du canal d'évacuation des gaz 135,136 est à une distance d1 du premier côté périphérique 133 qui est inférieure à la moitié de la distance h entre le premier côté périphérique 133 et le deuxième côté périphérique 134, on s'assure que le canal 135, 136 débute bien dans une première moitié du plot métallique 130a, 130b, 130b pour déboucher dans une deuxième moitié. Ainsi, l'évacuation des bulles lors du brasage est effectuée principalement sur la première moitié de la face de montage 132. Lorsque le composant dissymétrique est positionné sur la face de montage 132 en s'assurant que son élément électronique est positionné sur la première moitié on s'assure que l'élément électronique est sur une zone de la face de montage 132 où la densité de bulles est inférieure par rapport au reste de la face de montage 132.

La distance d1 entre le début du canal d'évacuation des gaz 135, 136 et le premier côté périphérique 133 du plot métallique 130a, 130b, 130c, 130d peut être inférieure à h/4, voire à h/8, de manière à améliorer l'évacuation de bulle sur la moitié où débute le canal.

Le premier canal 135 et le deuxième canal 136 débouchent respectivement au niveau d'un sommet de la face de montage 132. Les deux canaux 135, 136 sont notamment symétriques par rapport à un axe de symétrie Δ de la face de montage 132. Un premier plot 130a comprend uniquement le premier 135 et le deuxième 136 canal d'évacuation des gaz. Cependant, le plot métallique peut comprendre d'autres canaux d'évacuation de gaz comme par exemple illustré sur d'autres plots métalliques 130b, 130c, 130d. En particulier, ces plots métalliques 130b, 130c, 130d comprennent un troisième canal d'évacuation des gaz 137 similaire aux premier 135 et deuxième 136 canaux, si ce n'est que le troisième canal 137 débute en vis-à-vis du milieu du premier côté périphérique 133 et s'étend le long de l'axe de symétrie Δ pour déboucher sur un côté périphérique 134, notamment au milieu du deuxième côté périphérique 134. L'ajout du troisième canal 137 permet de diminuer la densité de bulles dans la première moitié de la face de montage 132 par rapport au premier plot métallique 130a.

Notamment, les directions du premier canal 135 et du deuxième canal 136 font respectivement un angle aigu supérieur ou égal à 45° avec le premier côté périphérique 133 de la face de montage 132. Par exemple, les directions du premier canal 135 et du deuxième canal 136 font respectivement un angle aigu de 65° avec le premier côté périphérique 133 de la face de montage 132.

Un quatrième canal d'évacuation des gaz 138, 139 peut s'étendre depuis un sommet contigu au premier côté périphérique 133 de la face de montage 132. Le quatrième canal 138, 139 est débouchant à son extrémité au niveau dudit sommet et non débouchant à son autre extrémité. En particulier, le quatrième canal 138, 139 s'étend dans une zone de la face de montage 132 délimitée par le premier canal 135 ou le deuxième canal 136 et une portion de la périphérie de la face de montage 132 qui comprend un seul sommet de la face de montage 132. Par exemple, un quatrième canal 138 s'étend dans une zone de la face de montage 132 délimitée par le premier canal 135 et la portion de la périphérie de la face de montage 132 qui est la plus proche du premier canal 135 et qui comprend un premier sommet contigu au premier côté périphérique 133. Par exemple, un autre quatrième canal 139 s'étend dans une zone de la face de montage 132 délimitée par le deuxième canal 136 et la portion de la périphérie de la face de montage 132 qui est la plus proche du premier canal 136 et qui comprend un deuxième sommet contigu au premier côté périphérique 133.

Notamment, le quatrième canal 138, 139 s'étend le long d'une direction passant par ledit sommet contigu au premier côté périphérique 133 vers le milieu du deuxième côté périphérique 134, en particulier au niveau de l'intersection de l'axe de symétrie Δ avec le deuxième côté périphérique 134. Par exemple, le quatrième canal 138, 139 fait un angle aigu avec le premier côté périphérique 133 compris entre 55 et 70°, voire égal à 61,5°.

Un cinquième canal d'évacuation des gaz 140, 141 peut s'étendre depuis le deuxième côté périphérique 134 opposé au premier côté périphérique 133. Le cinquième canal 140, 141 est débouchant à son extrémité au niveau du deuxième côté périphérique 134 et non débouchant à son autre extrémité. En particulier, le cinquième canal 140, 141 est compris dans une portion de la face de montage 132 délimitée par le troisième canal 137 et le premier 135 ou le deuxième 136 canal. Par exemple, un cinquième canal 140 est compris dans une portion de la face de montage 132 délimitée par le troisième canal 137 et le premier canal 135. Par exemple, un autre cinquième canal 141 est compris dans une portion de la face de montage 132 délimitée par le troisième canal 137 et le deuxième canal 136. Notamment, l'extrémité débouchante du cinquième canal 140, 141 est à une distance d2 à partir du milieu du deuxième côté périphérique 134. Cette distance d2 est égale à 2Lf/3 où Lf est la moitié du deuxième côté périphérique 134.

Les quatrième 138, 139 et cinquième 140, 141 canaux permettent de diminuer la densité de bulles dans les zones de la face de montage comprises entre les premier 135, deuxième 136 et troisième 137 canaux.

Les canaux d'évacuation s'étendent le long de la face de montage 132. En particulier, les canaux d'évacuation des gaz s'étendent suivant une direction rectiligne depuis leur première extrémité jusqu'à leur deuxième extrémité débouchante.

Par exemple, la largeur des canaux d'évacuation des gaz est comprise entre 100 et 400 µm. En particulier, les canaux ont une largeur de 300 µm.

En particulier, les plots métalliques 130a, 130b, 130c, 130d peuvent être en cuivre. Les plots métalliques 130a, 130b, 130c, 130d peuvent avoir une épaisseur comprise entre 35 et 250 µm. En particulier, les plots métalliques 130a, 130b, 130c, 130d ont une épaisseur de 105 µm.

Lors du montage du composant électronique dissymétrique sur la carte électronique 100, le composant électronique dissymétrique est brasé sur la face de montage 132 en positionnant l'élément électronique 150 du composant sur la portion de la face de montage 132 où débutent les canaux d'évacuation des gaz, en particulier sur la portion où débutent les premier 135, deuxième 136 et troisième 137 canaux d'évacuation des gaz.

Le composant électronique peut être monté sur la face de montage 132 comme expliqué dans ce qui suit.

Un dépôt de brasure est réalisé sur la face de montage 132. Un masque peut être utilisé pour empêcher le dépôt de brasure à des emplacements de la face de montage 132. En particulier, le masque occulte les canaux d'évacuation des gaz pour empêcher un dépôt de pâte à braser dans les canaux.

Le composant électronique est ensuite positionné sur la face de montage 132. Notamment, l'élément électronique 150 du composant électronique est en forme de pavé. En particulier, l'élément électronique 150 est en forme de parallélépipède, notamment de parallélépipède rectangle. Le composant électronique est monté sur la face de montage 132 de sorte que l'élément électronique 150 soit symétrique par rapport l'axe de symétrie Δ. Un côté 150a de l'élément électronique est sensiblement parallèle au premier côté périphérique 133 de la face de montage 132. Les débuts du premier canal 135 et du deuxième canal 136 peuvent être en vis-à-vis d'un point du côté 150a de l'élément électronique 150 qui est à une distance d3 à partir du milieu du côté 150a de l'élément électronique 150. Cette distance d3 est égale à L/3 où L est la moitié du côté 150a de l'élément électronique 150. Ce positionnement de l'élément électronique 150 permet de minimiser la densité de bulles sous l'élément électronique 150.

La carte électronique 100 est ensuite passée dans un four pour le brasage. Au début du brasage les gaz peuvent facilement s'échapper par les canaux d'évacuation des gaz car ceux-ci sont initialement libres de pâte à braser. Dans un moment ultérieur du brasage, la pâte à braser est suffisamment fluide pour s'écouler dans les canaux et permettre, une fois la brasure obtenue, une continuité de matière pour une dissipation thermique du composant électronique.

La carte électronique 100 peut être ensuite montée dans un dispositif d'alimentation électrique d'une machine électrique. Par exemple, le dispositif d'alimentation comprenant la carte électronique 100 peut être monté sur le boitier de la machine électrique. Notamment, l'ensemble formé du dispositif d'alimentation, de la machine électrique associée à une volute de compression de gaz forme un compresseur électrique de suralimentation de gaz à l'admission d'un moteur thermique.

Par élément électronique du composant électronique on entend la partie fonctionnelle du composant électronique. En particulier, cette expression ne désigne pas les conducteurs électriques du composant électronique qui acheminent l'énergie électrique vers la partie fonctionnelle. Cette partie fonctionnelle est par exemple une puce semi-conductrice.

L'invention ne se limite pas aux seuls exemples décrits ci-dessus. Les figures représentent des exemples particuliers de réalisation qui combinent plusieurs modes de réalisation. Cependant, les caractéristiques liées aux modes de réalisation peuvent-être indépendantes entre elles d'un mode à l'autre, ou combinées entre elles, comme cela ressort des revendications. Notamment, les plots métalliques 130a, 130b, 130c, 130d sont décrit avec plusieurs canaux d'évacuation, mais ils pourraient en comprendre un seul.

## Revendications

1. Ensemble comprenant :
- un composant électronique comprenant un boitier et un élément électronique (150) logé dans ledit boitier et
- une carte électronique (100) destinée à recevoir ledit composant électronique, ladite carte électronique (100) comprenant un plot métallique (130a, 130b, 130c, 130d) formant un pavé ayant une face, dite face de montage (132), destinée à recevoir le composant électronique par brasage, ladite face de montage (132) comportant au moins un canal (135, 136, 137) qui débouche sur la périphérie de la face de montage (132) et qui est configuré pour évacuer des gaz formés lors du brasage du composant électronique, le canal (135, 136, 137) débute à proximité d'un premier côté périphérique (133) de la face de montage (132) en s'étendant depuis une première moitié de la face de montage (132) jusqu'à une deuxième moitié de la face de montage (132), le canal (135, 136, 137) débute à une distance (d1) du premier côté périphérique (133), ladite distance (d1) étant inférieure à h/2 où h est la distance qui sépare le premier côté périphérique (133) d'un autre côté périphérique de la face (132), dit deuxième côté périphérique (134), qui lui est opposé,
**caractérisé en ce que** le canal débute à une première extrémité fermée à la diffusion de gaz et se termine à une deuxième extrémité ouverte à la diffusion de gaz, de sorte que lors du brasage les gaz se propagent dans une direction suivant la première extrémité vers la deuxième extrémité du canal et **en ce que** ledit composant électronique est brasé sur la face de montage (132), son élément électronique (150) étant positionné sur une portion de la face de montage (132) où débute le ou les canaux d'évacuation des gaz (135, 136, 137).

2. Ensemble selon la revendication précédente dans lequel la carte électronique (100) comprend une pluralité dudit canal (135, 136, 137).

3. Ensemble selon la revendication précédente dans lequel la carte électronique (100) comprend un premier canal (135) et un deuxième canal (136) débouchant au niveau d'un sommet respectif de la face de montage (132), les deux canaux (135, 136) étant symétriques par rapport à un axe de symétrie (Δ) de la face de montage (132).

4. Ensemble selon la revendication précédente dans lequel la carte électronique (100) comprend un troisième canal (137) débutant en vis-à-vis du milieu du premier côté périphérique (133) et s'étendant le long de l'axe de symétrie (Δ) de la face de montage (132) pour déboucher sur un côté périphérique (134) de la face de montage (132).

5. Ensemble selon l'une des revendications 2 à 4 dans lequel la carte électronique (100) comprend, comprend en outre un quatrième canal d'évacuation des gaz (138, 139) s'étendant depuis un sommet contigu au premier côté périphérique (133), ledit quatrième canal (138, 139) étant débouchant à son extrémité au niveau dudit sommet et non débouchant à son autre extrémité.

6. Ensemble selon l'une des revendications 2 à 5 dans lequel la carte électronique (100) comprend en outre un cinquième canal d'évacuation des gaz (140, 141) s'étendant depuis un deuxième côté périphérique (134) opposé au premier côté périphérique (133) ; ledit cinquième canal (140, 141) étant débouchant à son extrémité au niveau dudit deuxième côté périphérique (134) et non débouchant à son autre extrémité.

7. Ensemble selon la revendication 3 ou 4, dans lequel l'élément électronique est en forme de pavé et le composant électronique est monté sur la face de montage (132) de sorte que l'élément électronique (150) soit symétrique par rapport l'axe de symétrie (Δ), et a un côté (150a) sensiblement parallèle au premier côté périphérique (133) de la face de montage (132), e
ensemble dans lequel ledit côté (150a) de l'élément électronique (150) et les premier (135) et deuxième (136) et/ou troisième(137) canaux sont tels que les débuts du premier canal (135) et du deuxième canal (136) et/ou du troisième canal (137) sont en vis-à-vis d'un point dudit côté (150a) de l'élément électronique (150).

8. Procédé de montage d'un composant électronique sur une carte électronique (100) comprenant :
- la fourniture d'un ensemble selon l'une des revendications 1 à 7 ;
- le dépôt de brasure sur la face de montage (132) du plot métallique (130a, 130b, 130c, 130d) ;
- le dépôt du composant électronique sur la couche de brasure et le brasage du composant électronique sur la face de montage (132),
procédé dans lequel le dépôt de brasure s'effectue à l'aide d'un masque occultant le ou les canaux d'évacuation des gaz (135, 136, 137, 138, 139, 140, 141) de manière à empêcher un dépôt de brasure dans le ou lesdits canaux d'évacuation des gaz (135, 136, 137, 138, 139, 140, 141).

## Patentansprüche

1. Anordnung, umfassend:
- eine elektronische Komponente, die ein Gehäuse und ein in diesem Gehäuse untergebrachtes elektronisches Element (150) umfasst, und
- eine elektronische Karte (100) zur Aufnahme der elektronischen Komponente, wobei die elektronische Karte (100) einen Metallkontakt (130a, 130b, 130c, 130d) umfasst, der eine Fläche bildet, die als Montagefläche (132) bezeichnet wird und zur Aufnahme der elektronischen Bauteils durch Löten vorgesehen ist, wobei die Montagefläche (132) mindestens einen Kanal (135, 136, 137) aufweist, der am Umfang der Montagefläche mündet (132) und der so konfiguriert ist, dass er beim Löten der elektronischen Komponente entstehende Gase abführt, beginnt der Kanal (135, 136, 137) in der Nähe einer ersten Umfangsseite (133) der Montagefläche (132) und erstreckt sich von einer ersten Hälfte der Fläche (132) bis zu einer zweiten Hälfte der Montagefläche (132) verläuft, wobei der Kanal (135, 136, 137) in einem Abstand (d1) von der ersten Umfangsseite (133) beginnt, wobei der Abstand (d1) kleiner ist als h/2, wobei h der Abstand ist, der die erste Umfangsseite (133) von einer anderen Umfangsseite der Fläche (132), der sogenannten zweiten Umfangsseite (134), trennt, die ihr gegenüberliegt,
**dadurch gekennzeichnet, dass** der Kanal an einem ersten Ende beginnt, das für die Gasdiffusion geschlossen ist, und an einem zweiten Ende endet, das für die Gasdiffusion offen ist, so dass sich die Gase beim Löten in einer Richtung entlang des ersten Endes zum zweiten Ende des Kanals ausbreiten, und dass die elektronische Komponente auf die Montagefläche (132) gelötet wird, wobei ihr elektronisches Element (150) auf einem Abschnitt der Montagefläche (132) positioniert ist, wo der oder die Gasableitungskanäle (135, 136, 137) beginnen.

2. Anordnung nach dem vorhergehenden Anspruch, wobei die elektronische Karte (100) mehrere der genannten Kanäle (135, 136, 137) umfasst.

3. Anordnung gemäß dem vorhergehenden Anspruch, wobei die elektronische Karte (100) einen ersten Kanal (135) und einen zweiten Kanal (136) umfasst, die an einem jeweiligen Scheitelpunkt der Montagefläche (132) münden, wobei die beiden Kanäle (135, 136) symmetrisch zu einer Symmetrieachse (Δ) der Montagefläche sind (132) symmetrisch sind.

4. Anordnung gemäß dem vorhergehenden Anspruch, wobei die elektronische Karte (100) einen dritten Kanal (137) umfasst, der gegenüber der Mitte der ersten Seite beginnt (133) beginnt und sich entlang der Symmetrieachse (Δ) der Montagefläche erstreckt (132), um an einer Umfangsseite (134) der Montagefläche (132) zu münden.

5. Anordnung gemäß einem der Ansprüche 2 bis 4, wobei die elektronische Karte (100) umfasst außerdem einen vierten Gasabführungskanal (138, 139), der sich von einem an die erste Umfangsseite (133) angrenzenden Scheitelpunkt aus erstreckt, wobei der vierte Kanal (138, 139) an seinem Ende am Scheitelpunkt mündet und an seinem anderen Ende nicht mündet.

6. Anordnung nach einem der Ansprüche 2 bis 5, wobei die elektronische Karte (100) außerdem einen fünften Gasableitungskanal (140, 141) umfasst, der sich von einer zweiten Umfangsseite (134) gegenüber der ersten Umfangsseite erstreckt (133) wobei der fünfte Kanal (140, 141) an seinem Ende an der zweiten Umfangsseite (134) mündet und an seinem anderen Ende nicht mündet.

7. Anordnung nach Anspruch 3 oder 4, wobei das elektronische Element die Form eines Blocks hat und die elektronische Komponente so auf der Montagefläche (132) montiert ist, dass das elektronische Element (150) symmetrisch zur Symmetrieachse (Δ) symmetrisch ist und eine Seite (150a) aufweist, die im Wesentlichen parallel zur ersten Umfangsseite (133) der Montagefläche (132) wobei die Seite (150a) des elektronischen Elements (150) und der erste (135) und der zweite (136) und/oder der dritte (137) Kanal so sind, dass die Anfänge des ersten Kanals (135) und des zweiten Kanals (136) und/oder des dritten Kanals (137) einem Punkt der Seite (150a) des elektronischen Elements (150) gegenüberliegen.

8. Verfahren zum Montieren einer elektronischen Komponente auf einer elektronischen Karte (100), umfassend:
- Bereitstellen einer Anordnung gemäß einem der Ansprüche 1 bis 7;
- Aufbringen von Lot auf die Montagefläche (132) des Metallstifts (130a, 130b, 130c, 130d)
- Aufbringen des elektronischen Bauteils auf die Lötmittelschicht und Löten des elektronischen Bauteils auf die Montagefläche (132),
wobei das Aufbringen des Lötmittels mit Hilfe einer Maske erfolgt, die Gasauslasskanäle (135, 136, 137, 138, 139, 140, 141) verdeckt, um ein Aufbringen von Lot in den Gasauslasskanälen (135, 136, 137, 138, 139, 140, 141) verhindert wird.

## Claims

1. An assembly comprising:
- an electronic component comprising a housing and an electronic element (150) housed in said housing, and
- an electronic board (100) intended to receive said electronic component, said electronic board (100) comprising a metal pad (130a, 130b, 130c, 130d) forming a pad having a face, known as the mounting face (132), intended to receive the electronic component by soldering, said mounting face (132) comprising at least one channel (135, 136, 137) which opens onto the periphery of the mounting face (132) and which is configured to evacuate gases formed during the soldering of the electronic component, the channel (135, 136, 137) begins near a first peripheral side (133) of the mounting face (132), extending from a first half of the face mounting surface (132) to a second half of the mounting surface (132), the channel (135, 136, 137) begins at a distance (d1) from the first peripheral side (133), said distance (d1) being less than h/2, where h is the distance separating the first peripheral side (133) from another peripheral side of the face (132), called the second peripheral side (134), which is opposite it,
**characterized in that** the channel begins at a first end closed to gas diffusion and ends at a second end open to gas diffusion, so that during soldering the gases propagate in a direction following the first end towards the second end of the channel, and **in that** said electronic component is soldered onto the mounting face (132), its electronic element (150) being positioned on a portion of the mounting face (132) where the gas evacuation channel(s) (135, 136, 137) begin.

2. Assembly according to the previous claim, wherein the electronic board (100) comprises a plurality of said channels (135, 136, 137).

3. Assembly according to the previous claim, wherein the electronic board (100) comprises a first channel (135) and a second channel (136) opening at a respective vertex of the mounting face (132), the two channels (135, 136) being symmetrical with respect to an axis of symmetry (Δ) of the mounting face (132).

4. Assembly as in the preceding claim, wherein the electronic board (100) comprises a third channel (137) starting opposite the middle of the first side and extending along the axis of symmetry (Δ) of the mounting face to open onto a peripheral side (134) of the mounting face (132).

5. Assembly according to one of claims 2 to 4, wherein the electronic board (100) further comprises a fourth gas evacuation channel (138, 139) extending from a vertex adjacent to the first peripheral side (133), said fourth channel (138, 139) being open at its end at said vertex and closed at its other end.

6. Assembly according to one of claims 2 to 5, wherein the electronic board (100) further comprises a fifth gas evacuation channel (140, 141) extending from a second peripheral side (134) opposite the first peripheral side (133) said fifth channel (140, 141) opening at its end at said second peripheral side (134) and not opening at its other end.

7. Assembly according to claim 3 or 4, wherein the electronic element is in the form of a block and the electronic component is mounted on the mounting face (132) such that the electronic element (150) is symmetrical with respect to the axis of symmetry (Δ), and has a side (150a) substantially parallel to the first peripheral side (133) of the mounting face (132),
wherein said side (150a) of the electronic component (150) and the first (135) and second (136) and/or third (137) channels are such that the beginnings of the first channel (135) and the second channel (136) and/or the third channel (137) are opposite a point on said side (150a) of the electronic component (150).

8. Method of mounting an electronic component on an electronic board (100) comprising:
- providing an assembly according to one of claims 1 to 7;
- the deposition of solder on the mounting surface (132) of the metal pad (130a, 130b, 130c, 130d);
- depositing the electronic component on the solder layer and soldering the electronic component to the mounting face (132),
in which process the solder is deposited using a mask that obscures the gas evacuation channels (135, 136, 137, 138, 139, 140, 141) so as to prevent solder deposition in the gas evacuation channels (135, 136, 137, 138, 139, 140, 141).
